# EUROPEAN PATENT APPLICATION

(11) **EP 4 692 930 A1**
(43) Date of publication of application: **11.02.2026**
(21) Application number: 24780221.8
(22) Date of filing: 25.03.2024
(51) Int. Cl.: G03F 1/62

(54) **PELLICLE, PELLICLE SUPPORT, AND METHOD FOR MANUFACTURING PELLICLE**

(30) Priority: 28.03.2023 JP 2023051835
(71) Applicant: LINTEC CORPORATION, Itabashi-ku Tokyo 173-0001 (JP)
(72) Inventor: KAWAHARA Jun, Tokyo 173-0001 (JP)
(74) Representative: Gille Hrabal Partnerschaftsgesellschaft mbB Patentanwälte
(86) International application number: PCT/JP2024/011771
(87) International publication number: WO 2024/204105

(57) **Abstract**

An object is to provide a pellicle capable of improving impact resistance and suppressing generation of foreign matter. A pellicle (100) includes: a pellicle film (10); a support member (30) including a frame (31) and an opening (32); and a first reinforcing layer (40). The first reinforcing layer (40) is disposed in an area between the pellicle film (10) and the support member (30), where the pellicle film (10) and the support member (30) overlap each other in a plan view of the pellicle film (10) supported by the support member (30). The first reinforcing layer (40) contains at least one material selected from the group consisting of carbon nanotube, graphene, silicon carbide, silicon nitride, and boron nitride and the like. When the first reinforcing layer (40) contains carbon nanotubes, the carbon nanotubes are oriented in a vertical direction with respect to a support surface (34).

## Description

### TECHNICAL FIELD

The present invention relates to a pellicle, a pellicle support, and a pellicle production method.

### BACKGROUND ART

In a production process of a semiconductor device and the like, a target circuit pattern is formed on a substrate by, for instance, applying a photoresist on a substrate (e.g., a semiconductor wafer), irradiating the substrate, on which the photoresist is applied, with light using a photomask, and then removing the photoresist.

When the substrate is irradiated with light while the foreign matter adheres on the photomask, the attached foreign matter sometimes causes defects on the circuit pattern formed on the substrate. Accordingly, a pellicle having a pellicle film for catching the foreign matter is sometimes used in order to restrain the foreign matter from adhering on the photomask. The pellicle is provided above the photomask at a distance such that the pellicle film does not contact with the photomask.

Recently, use of extreme ultra violet (EUV) has been proposed in order to form a more intricate circuit pattern. EUV refers to a light whose wavelength is in a range from 1 nm to 100 nm. For instance, specifically, a light beam of a wavelength of approximately 13.5 nm ± 0.3 nm has come to be used as EUV. When the pellicle film is irradiated with EUV, the EUV passes through the pellicle film; however, a portion of the irradiated EUV is absorbed by the pellicle film. Light energy of the absorbed EUV is converted into thermal energy to raise the temperature of the pellicle film. Accordingly, it is required for the pellicle film to have EUV transparency, heat resistance, durability and the like.

For instance, Patent Literature 1 discloses that the strength of the pellicle film can be enhanced by subjecting the pellicle film to a heating (annealing) process.

Patent Literature 2 discloses a photolithography pellicle including a pellicle film and a pellicle frame, where the pellicle film is provided on an upper end surface of the pellicle frame through an adhesive or a sticky agent.

### CITATION LIST

### PATENT LITERATURE(S)

Patent Literature 1: JP 2020-91314 A
Patent Literature 2: JP 2020-98227 A

### SUMMARY OF THE INVENTION

### PROBLEM(S) TO BE SOLVED BY THE INVENTION

Patent Literature 1 discloses the method capable of enhancing the strength of the pellicle film. However, a method capable of further enhancing impact resistance of the pellicle has been desired.

The pellicle film of the pellicle of Patent Literature 2 is fixed on a support member (pellicle frame) through an adhesive or a sticky agent. The adhesive and sticky agent, which are materials not excellent in heat resistance, are possibly decomposed to produce foreign matter when being irradiated with high-energy light such as EUV.

An object of the invention is to provide a pellicle and a pellicle support capable of enhancing impact resistance and suppressing generation of foreign matter, and to provide a production method for producing the pellicle.

### MEANS FOR SOLVING THE PROBLEM(S)

[1] A pellicle includes: a pellicle film;
   a support member including a frame and an opening surrounded by the frame, the support member supporting the pellicle film; and
   a first reinforcing layer configured to reinforce the pellicle film, in which
   the frame has a support surface facing the pellicle film,
   the pellicle film has a first pellicle film surface facing the support member and a second pellicle film surface opposite the first pellicle film surface,
   the first reinforcing layer is disposed in an area where the pellicle film overlaps the support member in a plan view of the pellicle film supported by the support member, on a side of the first pellicle film surface between the pellicle film and the support member,
   the first reinforcing layer contains at least one material selected from the group consisting of carbon nanotube, graphene, graphite, diamond-like carbon, amorphous carbon, silicon, silicon carbide, silicon nitride, and boron nitride, and
   when the first reinforcing layer contains carbon nanotubes, the carbon nanotubes in the first reinforcing layer are oriented in a vertical direction with respect to the support surface of the frame.
[2] In the pellicle according to [1], the pellicle film is an inorganic thin film or an organic thin film.
[3] In the pellicle according to [1] or [2], the pellicle film contains at least one material selected from the group consisting of carbon nanotubes, graphene, graphite, diamond-like carbon, amorphous carbon, silicon, silicon carbide, silicon nitride, and boron nitride.
[4] In the pellicle according to any one of [1] to [3], the pellicle film includes carbon nanotubes.
[5] In the pellicle according to any one of [1] to [4], a material of the pellicle film is the same as a material of the first reinforcing layer.
[6] The pellicle according to any one of [1] to [5] further includes a second reinforcing layer disposed on a side of a second pellicle film surface.
[7] In the pellicle according to [6], the second reinforcing layer contains at least one material selected from the group consisting of carbon nanotube, graphene, graphite, diamond-like carbon, amorphous carbon, silicon, silicon carbide, silicon nitride, and boron nitride.
[8] In the pellicle according to [6] or [7],
   the second reinforcing layer includes carbon nanotubes, and
   the carbon nanotubes in the second reinforcing layer are oriented in a parallel direction with respect to the support surface of the frame.
[9] A pellicle support for supporting a pellicle film includes:
   a frame; and
   an opening surrounded by the frame, in which
   the frame has a support surface facing the pellicle film when the frame supports the pellicle film,
   a first reinforcing layer is disposed at an outer periphery of the opening on the support surface of the frame,
   the first reinforcing layer contains at least one material selected from the group consisting of carbon nanotube, graphene, graphite, diamond-like carbon, amorphous carbon, silicon, silicon carbide, silicon nitride, and boron nitride, and
   when the first reinforcing layer contains carbon nanotubes, the carbon nanotubes in the first reinforcing layer are oriented in a vertical direction with respect to the support surface of the frame.
[10] A method for producing a pellicle using the pellicle support according to [9] includes: attaching the pellicle film to a side of the support surface of the frame such that the pellicle film covers the opening and is supported by the first reinforcing layer.
[11] The method for producing a pellicle according to [10], further includes:
   before attaching the pellicle film to the pellicle support, disposing a second reinforcing layer on a second pellicle film surface of the pellicle film opposite a first pellicle film surface facing the pellicle support, in which
   in the disposing of the second reinforcing layer, the second reinforcing layer is disposed at a position where the pellicle film, the pellicle support, and the first reinforcing layer overlap each other when the pellicle film is viewed in a plan after attaching the pellicle film to the pellicle support.
[12] The method for producing a pellicle according to [10], further includes: disposing the second reinforcing layer in an area on a second pellicle film surface of the pellicle film opposite a first pellicle film surface facing the pellicle support, the area being where the pellicle film overlaps the pellicle support in a plan view of the pellicle film.
[13] In the method for producing a pellicle according to [11] or [12], the second reinforcing layer contains at least one material selected from the group consisting of carbon nanotube, graphene, graphite, diamond-like carbon, amorphous carbon, silicon, silicon carbide, silicon nitride, and boron nitride.
[14] In the method for producing a pellicle according to [13],
   the second reinforcing layer includes carbon nanotubes, and
   the second reinforcing layer is formed such that the carbon nanotubes in the second reinforcing layer are oriented in a parallel direction with respect to a film surface of the pellicle film.

According to the above aspects of the invention, a pellicle and a pellicle support capable of enhancing impact resistance and suppressing generation of foreign matter, and a method for producing the pellicle can be provided.

### BRIEF DESCRIPTION OF DRAWINGS

Fig. 1 is a plan view schematically illustrating an example of a pellicle according to a first exemplary embodiment.
Fig. 2 is a cross-sectional view illustrating a cross section taken along a II-II line in Fig. 1.
Fig. 3 is a plan view schematically illustrating an example of a pellicle according to a second exemplary embodiment.
Fig. 4 is a cross-sectional view illustrating a cross section taken along a IV-IV line in Fig. 3.
Fig. 5A is a plan view schematically illustrating a pellicle for evaluating a strength of a pellicle film.
Fig. 5B is a side-elevational view schematically illustrating the pellicle for evaluating the strength of the pellicle film.
Fig. 6 is a view schematically illustrating how the strength of the pellicle film is to be evaluated.

### DESCRIPTION OF EMBODIMENT(S)

### First Exemplary Embodiment

### Pellicle

A pellicle according to a first exemplary embodiment includes a pellicle film, a support member for supporting the pellicle film, and a first reinforcing layer for reinforcing the pellicle film.

It should be noted that ordinal numbers such as "first" and "second," which are herein attached to respective terms for the purpose of distinguishing their structures and the like, are not attached to respective terms for specifying their orders. Herein, when an ordinal number is attached in order to specify the order, a specific comment to the effect will be explicitly made. Accordingly, for instance, the "first" and "second" in a "first reinforcing layer" and "second reinforcing layer" (see later-described second exemplary embodiment) are attached to the term "reinforcing layer" for the purpose of distinguishing a plurality of reinforcing layers in view of the presence of mutually different plurality of reinforcing layers provided to the pellicle.

Herein, the first reinforcing layer, which is provided at an inner side with respect to the pellicle film, may also be referred to as an inner reinforcing layer, whereas the second reinforcing layer, which is provided at a surface side with respect to the pellicle film, may also be referred to as a surface reinforcing layer.

An example of the pellicle according to the first exemplary embodiment will be described below with reference to the attached drawings. The invention is by no means limited to the illustrated pellicle. It should be noted that some parts of the drawings, when being referenced for description herein, are enlarged or reduced in size for the convenience of description.

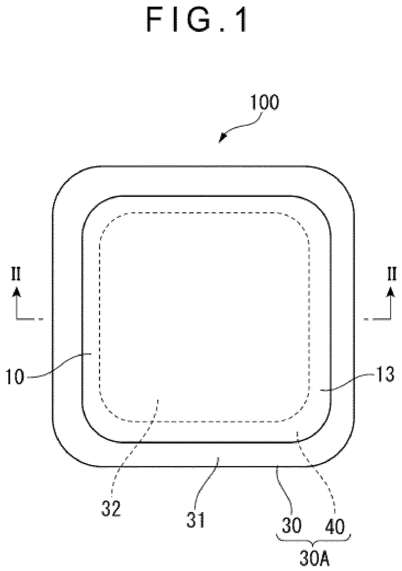

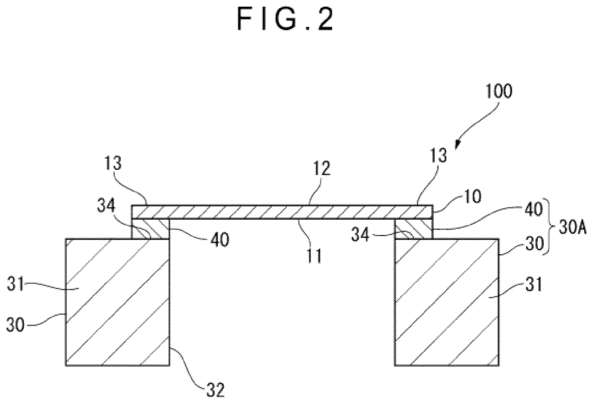

Figs. 1 and 2 illustrate a pellicle 100 as an example of the first exemplary embodiment. Fig. 1 illustrates a plan view of the pellicle 100 as viewed from a side attached with a pellicle film 10. Fig. 2 illustrates a cross-sectional view of the pellicle 100 illustrated in Fig. 1.

The pellicle 100 includes a pellicle film 10, a support member 30 for supporting the pellicle film 10, and a first reinforcing layer 40 for reinforcing the pellicle film 10.

### Support Member

The support member 30 includes a frame 31 and an opening 32 surrounded by the frame 31.

The frame 31 has a support surface 34 facing the pellicle film 10. Specifically, when supporting the pellicle film 10, the support surface 34 faces a first pellicle film surface 11 of the pellicle film 10. The support member 30 with the first reinforcing layer 40 being disposed on the support surface 34 will be sometimes referred to as a pellicle support 30A. The opening 32 penetrates through the support member 30 from a first side to a second side. The frame 31 and the opening 32 are each in a form of a rectangle. In the exemplary embodiment, all of the four corners of the outer profile of the frame 31 are rounded. However, the frame 31 is not necessarily shaped as in the exemplary embodiment.

Any known material can be used as the material of the support member 30. Examples of the usable material include resin materials (e.g., polyethylene), metal materials (e.g., aluminum, aluminum alloy, magnesium alloy, stainless steel, titanium, titanium alloy, and inver), ceramic materials (e.g., SiC and SiN), quartz, and fiber-reinforced plastic materials (e.g., carbon-fiber reinforced plastics and glass-fiber reinforced plastics).

### First Reinforcing Layer

The first reinforcing layer 40 is provided in an area where the pellicle film 10 overlaps the support member 30 in a plan view of the pellicle film 10 supported by the support member 30, on a side of the first pellicle film surface 11 between the pellicle film 10 and the support member 30. The first reinforcing layer 40 is provided along a peripheral portion 13 of the pellicle film 10. The first reinforcing layer 40 is also preferably in direct contact with the support surface 34.

The first reinforcing layer 40 may protrude into an opening 32 of the support member 30 in a plan view of the pellicle 100, to the extent that the first reinforcing layer 40 does not interfere with the process of image development (i.e., to the extent that the first reinforcing layer 40s does not block the exposure light necessary for the image development). Alternatively, an inner end portion (i.e., an end facing the opening 32) of the first reinforcing layer 40 may be formed in alignment with an inner end face (i.e., an end face facing the opening 32) of the frame 31 as illustrated in Fig. 2. Further alternatively, the inner end portion of the first reinforcing layer 40 may be formed so as to be positioned inward of the inner end face of the frame 31 as long as the inner end portion of the first reinforcing layer 40 does not interfere with the support and reinforcement of the pellicle film 10.

The thickness of the first reinforcing layer 40, which is preferably larger than the thickness of the pellicle film 10, is preferably 0.05 µm or more, more preferably 0.1 µm or more in order to reliably secure the impact resistance. In terms of productivity and suppression in foreign matter generated by heating, the thickness of the first reinforcing layer 40 is preferably 1 µm or less, more preferably 0.5 µm or less.

The first reinforcing layer 40 contains at least one material (reinforcing material) selected from the group consisting of carbon nanotube, graphene, graphite, diamond-like carbon, amorphous carbon, silicon, silicon carbide, silicon nitride, and boron nitride. With the first reinforcing layer 40 containing the above material(s), the pellicle 100 is capable of stably functioning against heat received when being exposed to light, exhibits excellent durability, and is unlikely to generate particles (i.e., minute particles of a size ranging from several tens of nanometers to several hundreds of nanometers) from the first reinforcing layer 40. The content of the above material(s) (reinforcing material) in the first reinforcing layer 40 is preferably 60 mass% or more, 70 mass% or more, 80 mass% or more, 90 mass% or more, 95 mass% or more, or 98 mass% or more. The first reinforcing layer 40 more preferably contains at least one material selected from the group consisting of carbon nanotube, graphene, silicon carbide, silicon nitride, and boron nitride. Still more preferably, the first reinforcing layer 40 is formed of carbon nanotubes or graphene. The nanocarbon material such as carbon nanotubes and graphene is excellent in heat resistance. The content of the nanocarbon material in the first reinforcing layer 40 is preferably 60 mass% or more, 70 mass% or more, 80 mass% or more, 90 mass% or more, 95 mass% or more, or 98 mass% or more.

When the first reinforcing layer 40 contains carbon nanotubes, the carbon nanotubes in the first reinforcing layer 40 are oriented in a vertical direction with respect to the support surface 34 of the frame 31. The first reinforcing layer 40 is also preferably a carbon nanotube forest. The carbon nanotube forest, which is a grown body of a plurality of carbon nanotubes grown on the support member or the substrate such that the carbon nanotubes are oriented in a vertical direction with respect to a surface of the support member or a surface of the substrate, is sometimes referred to as an "array." With the carbon nanotubes in the first reinforcing layer 40 being oriented in the vertical direction, shock-absorbing performance of the first reinforcing layer 40 is improved.

The phrase "oriented in the vertical direction" herein means that an object is oriented substantially perpendicular to the surface of the support member or the surface of the substrate. The term "substantially perpendicular" means that an angle of the orientation direction of the material in the first reinforcing layer (e.g., carbon nanotubes) with respect to the surface of the support member or the surface of the substrate is 90 ± 20 degrees (i.e., in a range from 70 degrees to 110 degrees).

The first reinforcing layer 40 preferably contains carbon nanotubes, more preferably substantially consists solely of carbon nanotubes. The phrase "substantially consists solely of carbon nanotube" herein means that 98 mass% or more of the material of the first reinforcing layer 40, except for a metal catalyst used in producing carbon nanotubes, is carbon nanotubes. Specifically, the first reinforcing layer that "substantially consists solely of carbon nanotubes" means that a mass percentage of the carbon nanotubes to a total mass of the first reinforcing layer 40 is 98 mass% or more, the total mass being calculated by subtracting the mass of the metal catalyst used in producing carbon nanotubes and contained in the first reinforcing layer 40. When the first reinforcing layer 40 substantially consists solely of carbon nanotubes, inevitable impurities (i.e., a substance(s) not intentionally added in the first reinforcing layer 40 and contained in raw material or mixed in a production process) may be contained or not contained in the first reinforcing layer 40.

When the first reinforcing layer 40 contains carbon nanotubes, the type of the carbon nanotubes contained in the first reinforcing layer 40, which is not specifically limited, is preferably at least one type selected from the group consisting of multi-walled carbon nanotube (MWCNT), few-walled carbon nanotube (FWCNT), double-walled carbon nanotube (DWCNT), and single-walled carbon nanotube (SWCNT).

### Pellicle Film

The pellicle film 10 includes the first pellicle film surface 11 facing the support member 30 and a second pellicle film surface 12 opposite the first pellicle film surface 11. The peripheral portion 13 of the pellicle film 10 is fixed on a part of the support surface 34 of the frame 31 to cover the opening 32 of the support member 30. It is preferable that the pellicle film 10 and the first reinforcing layer 40 of the pellicle 100 are in direct contact with each other.

It is preferable that the pellicle film 10 is an inorganic thin film or an organic thin film.

It is preferable that the pellicle film 10 contains at least one material selected from the group consisting of carbon nanotubes, graphene, graphite, diamond-like carbon, amorphous carbon, silicon, silicon carbide, silicon nitride, and boron nitride.

The pellicle film 10 preferably contains carbon nanotubes, also preferably substantially consists solely of carbon nanotubes. The phrase "substantially consists solely of carbon nanotubes" herein means that 98 mass% or more of the material in the pellicle film, except for a metal catalyst used in producing carbon nanotubes, is carbon nanotubes. Specifically, the pellicle film that "substantially consists solely of carbon nanotubes" means that a mass percentage of the carbon nanotubes to a total mass of the pellicle film 10 is 98 mass% or more, the total mass being calculated by subtracting the mass of the metal catalyst used in producing carbon nanotubes and contained in the pellicle film 10. When the pellicle film 10 substantially consists solely of carbon nanotubes, inevitable impurities (i.e., a substance(s) not intentionally added in the pellicle film 10 and contained in raw material or mixed in a production process) may be contained or not contained in the pellicle film 10.

The type of the carbon nanotubes contained in the pellicle film 10, which is not specifically limited, is preferably at least one type selected from the group consisting of multi-walled carbon nanotube, few-walled carbon nanotube, double-walled carbon nanotube, and single-walled carbon nanotube.

In the exemplary embodiment, the multi-walled carbon nanotube is, for instance, a carbon nanotube having 4 to 20 coaxial layers and a diameter ranging from 4 nm to 100 nm. The few-walled carbon nanotube is, for instance, a carbon nanotube having 2 or 3 coaxial layers and a diameter ranging from 2 nm to 8 nm. The single-walled carbon nanotube is a carbon nanotube of a single layer and having a tube diameter ranging from 0.2 nm to 5 nm.

The carbon nanotube is produced by, for instance, a chemical vapor deposition method, a laser abrasion method, or an arc discharge method.

In the exemplary embodiment, the length of the carbon nanotube is, for instance, preferably in a range from 0.1 µm to 1,000 µm.

In the exemplary embodiment, the length of the carbon nanotube is more preferably 0.5 µm or more, still more preferably 1 µm or more.

In the exemplary embodiment, the length of the carbon nanotube is more preferably 600 µm or less, still more preferably 400 µm or less.

In the exemplary embodiment, the cross-sectional diameter of the carbon nanotube is preferably in a range from 0.2 nm to 50 nm.

In the exemplary embodiment, the cross-sectional diameter of the carbon nanotube is more preferably 0.5 nm or more, still more preferably 1 nm or more.

In the exemplary embodiment, the cross-sectional diameter of the carbon nanotube is more preferably 30 nm or less, still more preferably 20 nm or less.

In order to improve transparency to exposure light, the pellicle film according to the exemplary embodiment is preferably self-supported. The pellicle film that is "self-supported" means that the pellicle film is a film standing by itself, and, in other words, a film having self-supportable properties (sometimes referred to as a self-supported film). In other words, the self-supported pellicle film is a film capable of keeping its shape by the pellicle film itself even without the presence of a base material or the like.

In the pellicle 100, the material of the pellicle film 10 and the material of the first reinforcing layer 40 may be the same or different. For instance, it is also preferable that both the material of the pellicle film 10 and the material of the first reinforcing layer 40 are carbon nanotube. With the pellicle film 10 and the first reinforcing layer 40 being made of the same material, adhesion between the pellicle film 10 and the first reinforcing layer 40 can be enhanced.

The thickness of the pellicle film according to the exemplary embodiment, which is not specifically limited, is preferably in a range from 3 nm to 1,000 nm. The thickness of the pellicle film is preferably 10 nm or more, more preferably 20 nm or more, and still more preferably 30 nm or more. The thickness of the pellicle film is preferably 600 nm or less, more preferably 300 nm or less. With the thickness of the pellicle film being, for instance, in a range from 3 nm to 1,000 nm, the strength of the pellicle film is further enhanced and EUV transparency can be more easily ensured.

### Production Method of Pellicle

A production method of the pellicle according to the first exemplary embodiment (sometimes referred to as a production method of the first exemplary embodiment hereinafter) will be described below. The production method of the first exemplary embodiment includes a step for producing the pellicle using the pellicle support 30A. More specifically, the production method of the first exemplary embodiment includes the following Step (P1).

In Step P1, the pellicle film 10 is attached so as to cover the opening 32 on the side of the support surface 34 of the frame 31 of the pellicle support 30A and so as to be supported by the first reinforcing layer 40.

The production method of the first exemplary embodiment optionally includes a step of producing the pellicle support 30A and a step of producing the pellicle film 10 before Step P1.

### Production Method of Pellicle Support

The method for producing the pellicle support 30A includes Step PS1 of forming the first reinforcing layer 40 on the support surface 34 of the support member 30.

The first reinforcing layer 40 only needs to be formed using a material selected as appropriate depending on the material of the pellicle film 10, the area for supporting the pellicle film 10, and the like. The method for forming the first reinforcing layer 40 only needs to be selected as appropriate depending on the material to be used.

When the first reinforcing layer 40 is a layer containing carbon nanotubes (CNT layer), the CNT layer can be formed by, for instance, a chemical vapor deposition (CVD) method, a laser abrasion method, or an arc discharge method. The CNT layer may be formed by: directly forming the CNT layer on the support surface 34 of the support member 30 by the CVD method; forming the CNT layer on a substrate and then transferring the CNT layer formed on the substrate onto the support surface 34; or fixing a substrate, on which the CNT layer is formed, on the support surface 34.

The first reinforcing layer 40, which is formed to the extent that the first reinforcing layer 40 does not interfere with the process of image development (i.e., to the extent that the first reinforcing layer 40 does not block the exposure light necessary for the image development), enables an increased content of carbon nanotubes in the first reinforcing layer 40 (for instance, a mass of the carbon nanotubes per a unit area of the film) compared to the pellicle film 10. As a result, the strength of the first reinforcing layer 40 is improved and the impact resistance of the pellicle film 10 is also improved.

When the first reinforcing layer 40 is a carbon nanotube forest, the carbon nanotube forest can be formed by growing a plurality of carbon nanotubes directly on the support surface 34 of the support member 30 such that the carbon nanotubes are oriented vertically relative to the support surface 34. Alternatively, after forming the carbon nanotube forest on a substrate, the substrate may be fixed on the support surface 34.

When a CNT layer is formed on a substrate, the substrate may be any known substrate selected as appropriate. For instance, at least one substrate selected from the group consisting of a plastic substrate, glass substrate, silicon substrate, and metal substrate (i.e., a substrate containing metal such as iron, copper, and the like or an alloy thereof (e.g., stainless steel)) may be used. A silicon dioxide film may be laminated on a surface of the substrate. The substrate on which the CNT layer (the first reinforcing layer 40) is formed may be fixed on the support surface 34 via an adhesion member (e.g., double-stick tape).

The carbon nanotubes to be grown on the substrate through chemical vapor deposition is preferably at least one type selected from the group consisting of multi-walled carbon nanotube, few-walled carbon nanotube, double-walled carbon nanotube, and single-walled carbon nanotube.

When the first reinforcing layer 40 is a layer containing graphene (graphene layer), the graphene layer as the first reinforcing layer 40 can also be formed by the CVD method. For instance, the graphene layer may be formed directly on the support surface 34 of the support member 30 by the CVD method or, alternatively, may be formed by forming a graphene layer on a metal-foil base material (e.g., Ni foil or Cu foil) by the CVD method and subsequently transferring the graphene layer formed on the base material onto the support surface 34. The graphene layer as the first reinforcing layer 40 may be single-layered (i.e., composed of a single layer) or, alternatively, may be multi-layered (i.e., having two or more layers) in order to enhance the effect for reinforcing the pellicle film. Since the first reinforcing layer 40 is formed to the extent that the first reinforcing layer 40 does not interfere with the process of the image development, even a multi-layered graphene layer does not cause any problems during the process of the image development. In the case of the multi-layered graphene layer, the graphene layer may be formed multi-layered in advance and then may be transferred onto the support surface 34.

Alternatively, the first reinforcing layer 40 can be formed by dispersing the material (reinforcing material) to be contained in the first reinforcing layer 40 in a solvent to prepare a reinforcing material dispersion, applying the reinforcing material dispersion on the support surface 34 of the support member 30, and evaporating the solvent to form a film formed of the reinforcing material as the first reinforcing layer 40.

### Method for Producing Pellicle Film

The method for producing the pellicle film 10, which is not specifically limited, only needs to be selected as appropriate depending on the material to be used.

An example of a preferred method for producing a pellicle film includes, for instance, a step of dispersing carbon nanotubes (Step PE1), a step of precipitating and depositing the dispersed carbon nanotubes on an air-permeable member to obtain a carbon nanotube film product formed in mat form on the air-permeable member (Step PE2), and a step of removing the air-permeable member from the carbon nanotube film product to obtain a pellicle film (Step PE3).

First, in Step PE1, carbon nanotubes are dispersed in a liquid to prepare a carbon nanotube dispersion in which the carbon nanotubes are dispersed in the liquid. The liquid is preferably a liquid containing water. The carbon nanotube dispersion may contain carbon nanotubes only, or may contain, in addition to the carbon nanotubes, various additives such as a dispersant for dispersing the carbon nanotubes.

Next, in Step PE2, the dispersed carbon nanotubes are precipitated and deposited on an air-permeable member. For instance, the carbon nanotube dispersion prepared in Step PE1 is filtered through a filtration membrane serving as an air-permeable member, so that the carbon nanotubes are precipitated and deposited to form a carbon nanotube film product formed in mat form on the filtration membrane. As the filtration membrane, for instance, a membrane filter or the like is preferably used.

Next, in Step PE3, the filtration membrane is removed from the carbon nanotube film product formed in mat form, whereby a pellicle film including carbon nanotubes is obtained. Before the filtration membrane is removed from the fiber film product formed in mat form, or after the filtration membrane is removed from the fiber film product formed in mat form, a drying step may be provided as necessary. The obtained pellicle film is a self-supported film.

The pellicle 100 is used, for instance, as a dustproof cover for producing semiconductor devices, IC packages, print boards, liquid crystal or organic EL displays, and the like. The pellicle 100 is used, for instance, while being disposed above a photomask so as to be spaced from the photomask such that the first pellicle film surface 11 faces the photomask. Use of the pellicle 100 inhibits adhesion of foreign matter to the photomask.

### Advantage(s) of First Exemplary Embodiment

With the use of the pellicle and the pellicle support according to the first exemplary embodiment, since the first reinforcing layer 40 is interposed between the pellicle film 10 and the support member 30, the pellicle film 10 is unlikely to be damaged, thereby improving impact resistance of the pellicle 100.

In the pellicle and the pellicle support according to the first exemplary embodiment, the first reinforcing layer 40 is formed of a material having excellent heat resistance, rather than an adhesive layer or a pressure-sensitive adhesive layer, and is therefore unlikely to be decomposed even when being irradiated with high-energy light (e.g., EUV). Therefore, according to the pellicle and the pellicle support of the first exemplary embodiment, the generation of foreign matter can be suppressed as compared with a pellicle in which the pellicle film is fixed to the support via an adhesive layer or a pressure-sensitive adhesive layer.

When the first reinforcing layer 40 of the pellicle (and the pellicle support) according to the first exemplary embodiment is a CNT layer in which carbon nanotubes are oriented in the vertical direction (e.g., carbon nanotube forest), the CNT layer in which carbon nanotubes are oriented in the vertical direction exhibits further enhanced impact resistance as compared with a CNT layer in which carbon nanotubes are oriented in a horizontal direction, supposing that the reinforcing layers contain the same mass of carbon nanotubes.

In the pellicle and the pellicle support according to the first exemplary embodiment, the first reinforcing layer 40 is positioned in an area where the pellicle film 10 overlaps the support member 30 in a plan view of the pellicle 100. Accordingly, the transparency of the first reinforcing layer 40 may be low. Thus, the number of options for the material usable for the first reinforcing layer 40 is increased and the content of the reinforcing material (for instance, a mass of the reinforcing material (e.g., carbon nanotubes) per a unit area of the film) in the first reinforcing layer 40 can be increased as compared with the pellicle film 10. As a result, the strength of the first reinforcing layer 40 is improved and the impact resistance of the pellicle 100 is also improved.

With the use of the pellicle and the pellicle support of the first exemplary embodiment, since the impact resistance is improved, the number for exchanging the pellicle is reduced and the productivity of the production process using the pellicle (e.g., production process of a semiconductor device and the like) can be improved.

According to the production method of the first exemplary embodiment, the pellicle with improved impact resistance can be produced.

### Second Exemplary Embodiment

### Pellicle

Next, the details of the pellicle according to a second exemplary embodiment will be described below. In the description of the second exemplary embodiment, the same components as those in the first exemplary embodiment are denoted by the same reference signs and names to simplify or omit an explanation of the components. Further, any structures and materials that are not specified in the second exemplary embodiment may be the same as the structures and materials described in the first exemplary embodiment.

The pellicle according to the second exemplary embodiment is different from the pellicle according to the first exemplary embodiment in that a second reinforcing layer is provided on a side of a second pellicle film surface. The rest of the arrangement of the pellicle is the same as that in the first exemplary embodiment.

Specifically, the pellicle film in the second exemplary embodiment is reinforced by being held between the first reinforcing layer and the second reinforcing layer at its peripheral portion, and is supported by the support member.

An example of the pellicle according to the second exemplary embodiment will be described below with reference to the attached drawings. The invention is by no means limited to the illustrated pellicle.

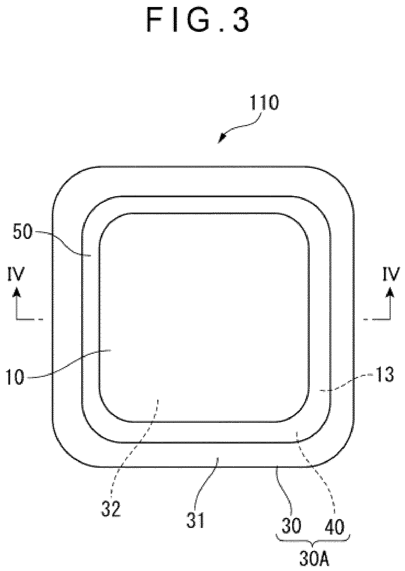

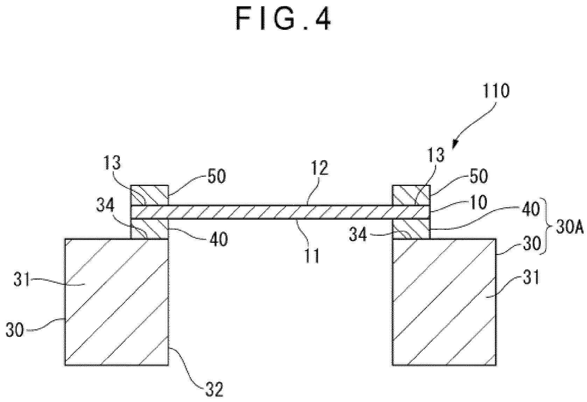

Figs. 3 and 4 illustrate a pellicle 110 as an example of the second exemplary embodiment. Fig. 3 is a plan view of the pellicle 110 as viewed in plan from a side on which the pellicle film 10 is disposed, and Fig. 4 is a sectional view of the pellicle 110 illustrated in Fig. 3.

The pellicle 110 includes the pellicle film 10, the support member 30 for supporting the pellicle film 10, and the first reinforcing layer 40 and a second reinforcing layer 50 that reinforce the pellicle film 10.

### Second Reinforcing Layer

The second reinforcing layer 50 is disposed on the side of the second pellicle film surface 12. The second reinforcing layer 50 is provided along the peripheral portion 13 of the pellicle film 10.

The second reinforcing layer 50 is preferably disposed in an overlapping area of the pellicle film 10 and the support member 30 in a plan view of the pellicle film 10 supported by the support member 30. It is preferable that the pellicle film 10 and the second reinforcing layer 50 in the pellicle 110 are in direct contact with each other.

The thickness of the second reinforcing layer 50, which is preferably larger than the thickness of the pellicle film 10, is preferably 0.05 µm or more, more preferably 0.1 µm or more in order to reliably secure the impact resistance. In terms of productivity and suppression of foreign matter generated by heating, the thickness of the second reinforcing layer 50 is preferably 1 µm or less, more preferably 0.5 µm or less.

The second reinforcing layer 50 may protrude into an opening 32 of the support member 30 in a plan view of the pellicle 110, to the extent that the second reinforcing layer 50 does not interfere with the process of the image development (i.e., to the extent that the second reinforcing layer 50 does not block exposure light required for the image development). Alternatively, an inner end portion of the second reinforcing layer 50 may be formed in alignment with at least one of an inner end face of the frame 31 or an inner end face of the first reinforcing layer 40, as illustrated in Fig. 4. Further alternatively, the inner end portion of the second reinforcing layer 50 may be disposed inward of the inner end portion of the frame 31, provided that such disposition does not interfere with the reinforcement of the pellicle film 10.

The second reinforcing layer 50 preferably contains at least one material (reinforcing material) selected from the group consisting of carbon nanotube, graphene, graphite, diamond-like carbon, amorphous carbon, silicon, silicon carbide, silicon nitride, and boron nitride. With the second reinforcing layer 50 containing the above material(s), the pellicle 110 is capable of stably functioning against heat received when being exposed to light, exhibits excellent durability, and is unlikely to generate particles from the second reinforcing layer 50. The content of the above material(s) (reinforcing material) in the second reinforcing layer 50 is preferably 60 mass% or more, 70 mass% or more, 80 mass% or more, 90 mass% or more, 95 mass% or more, or 98 mass% or more. The second reinforcing layer 50 more preferably contains at least one material selected from the group consisting of carbon nanotube, graphene, silicon carbide, silicon nitride, and boron nitride. Still more preferably, the second reinforcing layer 50 is formed of carbon nanotubes or graphene. The nanocarbon material such as carbon nanotube and graphene is excellent in heat resistance. Accordingly, the second reinforcing layer 50 containing the nanocarbon material exhibits improved heat resistance. The content of the nanocarbon material in the second reinforcing layer 50 is preferably 60 mass% or more, 70 mass% or more, 80 mass% or more, 90 mass% or more, 95 mass% or more, or 98 mass% or more. In the pellicle 110, the material of the pellicle film 40 and the material of the first reinforcing layer 50 may be the same or different.

The second reinforcing layer 50 preferably contains carbon nanotubes, more preferably substantially consists solely of carbon nanotubes. The phrase "substantially consists solely of carbon nanotubes" herein means that 98 mass% or more of the material of the second reinforcing layer 50, except for a metal catalyst used in producing carbon nanotubes, is carbon nanotubes. Specifically, the second reinforcing layer 50 that "substantially consists solely of carbon nanotubes" means that a mass percentage of the carbon nanotubes to a total mass of the second reinforcing layer 50 is 98 mass% or more, the total mass being calculated by subtracting the mass of the metal catalyst used in producing carbon nanotubes and contained in the second reinforcing layer 50. When the second reinforcing layer 50 substantially consists solely of carbon nanotubes, inevitable impurities (i.e., a substance(s) not intentionally added in the second reinforcing layer 50 and contained in raw material or mixed in a production process) may be contained or not contained in the second reinforcing layer 50.

When the second reinforcing layer 50 contains carbon nanotubes, the carbon nanotube in the second reinforcing layer 50 are preferably oriented in a parallel direction with respect to the support surface 34 of the frame 31. In other words, a long axis of each of carbon nanotubes is preferably oriented in a direction along the support surface 34 of the frame 31. The carbon nanotubes in the second reinforcing layer 50, which are oriented as described above, causes entanglement with the pellicle film whose carbon nanotubes are oriented similarly in the parallel direction, so that improvement in the reinforcing effect is expectable. It should be noted that the carbon nanotubes in the second reinforcing layer 50 may be oriented in the vertical direction with respect to the support surface 34 of the frame 31.

### Pellicle Film

The pellicle film 10 of the second exemplary embodiment is the same as that in the first exemplary embodiment.

In the pellicle 110, the material of the pellicle film 10 and the material of the second reinforcing layer 50 may be the same or different. For instance, it is also preferable that both the material of the pellicle film 10 and the material of the second reinforcing layer 50 are carbon nanotube. With the pellicle film 10 and the second reinforcing layer 50 being made of the same material, adhesion between the pellicle film 10 and the second reinforcing layer 50 can be enhanced.

Additionally, the material of the pellicle film 10, the material of the first reinforcing layer 40, and the material of the second reinforcing layer 50 may be the same or different. With the use of the same material for the pellicle film 10 and the first and second reinforcing layers 40, 50, adhesion between these components is improved. The material of the pellicle film 10 and the material of the first and second reinforcing layers 40, 50 are preferably carbon nanotubes.

### Production Method of Pellicle

A production method of the pellicle according to the second exemplary embodiment (sometimes referred to as a production method of the second exemplary embodiment hereinafter) will be described below.

The production method of the second exemplary embodiment also includes, as described in the first exemplary embodiment, a step of producing the pellicle using the pellicle support 30A. More specifically, the production method of the second exemplary embodiment may include Steps (P1) and (P2) below, or alternatively may include Steps (P1) and (P3) below.

In Step P1, the pellicle film 10 is attached so as to cover the opening 32 on the side of the support surface 34 of the frame 31 of the pellicle support 30A and so as to be supported by the first reinforcing layer 40. Step (P1) is the same as in the first exemplary embodiment.

In Step (P2), the second reinforcing layer 50 is disposed in an area on the second pellicle film surface 12 that is opposite the first pellicle film surface 11 facing the pellicle support 30A of the pellicle film 10, the area being where the pellicle film 10 overlaps the pellicle support 30A in a plan view of the pellicle film 10. In other words, in Step (P2), after producing the pellicle 100 of the first exemplary embodiment, the second reinforcing layer 50 is disposed on the second pellicle film surface 12 of the pellicle film 10.

In Step (P3), before the pellicle film 10 is attached to the pellicle support 30A, the second reinforcing layer 50 is disposed on the second pellicle film surface 12 of the pellicle film 10 opposite the first pellicle film surface 11 facing the pellicle support 30A.

In Step (P3) (the step of disposing the second reinforcing layer), the second reinforcing layer 50 is disposed in an area or a position, where the pellicle film 10, the pellicle support 30A, and the first reinforcing layer 40 overlap each other when the pellicle film 10 is viewed in a plan after the pellicle film 10 is attached to the support member 30.

In other words, in Step (P3), after the second reinforcing layer 50 is disposed on the pellicle film 10, the pellicle film 10 provided with the second reinforcing layer 50 is attached to the support member 30 (pellicle support 30A) provided with the first reinforcing layer 40.

An example of a method for providing the second reinforcing layer 50 on the pellicle film 10 is to form the second reinforcing layer 50 at a predetermined position on the pellicle film 10.

The second reinforcing layer 50 only needs to be formed using a material selected as appropriate depending on the material of the pellicle film 10, the area of the second reinforcing layer 50 disposed on the pellicle film 10, and the like. The method for forming the second reinforcing layer 50 only needs to be selected as appropriate depending on the material to be used.

For instance, the material (reinforcing material) to be contained in the second reinforcing layer 50 may be dispersed in a solvent to prepare a reinforcing material dispersion. The reinforcing material dispersion may then be applied to the pellicle film 10, and the solvent may be evaporated to form a film of the reinforcing material as the second reinforcing layer 50.

When the second reinforcing layer 50 containing carbon nanotubes is formed in the production method of the second exemplary embodiment, the carbon nanotubes in the second reinforcing layer 50 are preferably oriented in a parallel direction with respect to the support surface 34 of the frame 31.

The second reinforcing layer 50, which is formed to the extent that the second reinforcing layer 50 does not interfere with the process of image development (i.e., to the extent that the second reinforcing layer 50 does not block the exposure light necessary for the image development), enables an increased content of carbon nanotubes in the second reinforcing layer 50 (for instance, a mass of the carbon nanotubes per a unit area of the film) compared to the pellicle film 10. As a result, the strength of the second reinforcing layer 50 is improved and the impact resistance of the pellicle film 10 is also improved.

The production method of the second exemplary embodiment optionally includes a step of producing the pellicle support and a step of producing the pellicle film described in the first exemplary embodiment before Step P1.

The pellicle 110 is used as a dustproof cover as in the pellicle 100 of the first exemplary embodiment.

### Advantage(s) of Second Exemplary Embodiment

The pellicle of the second exemplary embodiment achieves the same advantages as those in the first exemplary embodiment. Further, the pellicle according to the second exemplary embodiment, which includes the second reinforcing layer 50 on the side of the second pellicle film surface 12, provides further reinforcement for the pellicle film 10 and improvement in the impact resistance of the pellicle 110.

In the pellicle according to the second exemplary embodiment, the second reinforcing layer 50 is also positioned in an area where the pellicle film 10 overlaps the support member 30 in a plan view of the pellicle 110. Accordingly, the transparency of the second reinforcing layer 50 may also be low. Thus, the number of options for the material usable for the second reinforcing layer 50 is increased and the content of the reinforcing material (for instance, a mass of the reinforcing material (e.g., carbon nanotubes) per a unit area of the film) in the second reinforcing layer 50 can be increased as compared with the pellicle film 10. As a result, the strength of the second reinforcing layer 50 is improved and the impact resistance of the pellicle 110 is also improved. The second reinforcing layer 50 is provided on an area on the peripheral portion 13 of the pellicle film 10. Accordingly, the peripheral portion 13 of the pellicle film 10 can be more effectively protected.

In the pellicle according to the second exemplary embodiment, the second reinforcing layer 50 is formed of a material having excellent heat resistance, rather than an adhesive layer or a pressure-sensitive adhesive layer, and is therefore unlikely to be decomposed even when being irradiated with high-energy light (e.g., EUV). Therefore, the generation of foreign matter can be suppressed even when the second reinforcing layer 50 is disposed as in the pellicle according to the second exemplary embodiment.

According to the production method of the second exemplary embodiment, the pellicle with further improved impact resistance can be produced.

### Modification of Embodiment(s)

The invention is not limited to the above exemplary embodiments and includes any modification, improvement, and the like as long as the object of the invention can be achieved.

Although the examples of the pellicle according to the first and second exemplary embodiments have been described with reference to Fig. 1 to Fig. 4, the pellicle of the invention is not limited to the examples of the pellicle.

The pellicle of the invention may employ any form as long as the advantageous effects of the pellicle including the above-described pellicle films according to the above first and second exemplary embodiments are obtained. The shape, dimensions, etc. of portions of members constituting the pellicles according to the first and second exemplary embodiments can be determined according to, for instance, the dimensions of a photomask (not illustrated) for which the pellicles according to the first and second exemplary embodiments is used.

For instance, the pellicle film 10 and the support 30 of the pellicles 100,110 illustrated in Fig. 1 to Fig. 4 are each formed in a rectangular shape. The pellicle of the invention is not limited thereto and may be formed in any desired shape such as a circular, elliptical, or polygonal shape.

In the pellicle 110 illustrated in Fig. 3 and Fig. 4, the second reinforcing layer 50 is provided on the peripheral portion 13 of the pellicle film 10. However, the pellicle of the invention is not limited thereto. For instance, the second reinforcing layer 50 may be not only provided on the peripheral portion 13 of the pellicle film 10 but also may protrude into an area of the support surface 34 on which the pellicle film 10 is not attached. The second reinforcing layer 50 may protrude toward the support surface 34 to cover a side portion of the pellicle film 10. The pellicle film 10 can be restrained from being peeled off from the support member 30 by covering the side portion of the pellicle film 10 with the second reinforcing layer 50. The second reinforcing layer 50 may protrude from the peripheral portion 13 of the pellicle film 10 to be in contact with a part or an entirety of an exposed part of the support surface 34 on which the first reinforcing layer 40 is not disposed.

The peripheral portion 13 of the pellicle film 10 of the pellicles 100, 110 as illustrated in Figs. 1 to 4 is exemplarily fixed by the first reinforcing layer 40 provided on a part of the support surface 34 of the support member 30. The pellicle of the invention is not limited thereto, and the peripheral portion 13 of the pellicle film 10 may be fixed by the first reinforcing layer 40 provided for the entire surface of the support surface 34 of the support. For instance, the first reinforcing layer 40 may be not only provided on the area for supporting the pellicle film 10 but also may protrude into an area of the support surface 34 on which the pellicle film 10 is not attached. The first reinforcing layer 40 protruding in this manner may be in contact with the second reinforcing layer 50 protruding as described above. By arranging the first and second reinforcing layers 40, 50 in contact with each other, the peripheral portion 13 of the pellicle film 10 is held between the first reinforcing layer 40 and the second reinforcing layer 50, thereby further improving the effect for reinforcing the pellicle film 10.

### Examples

The invention will be described below in more detail with reference to Examples. The invention is by no means limited to these Examples.

### Example 1

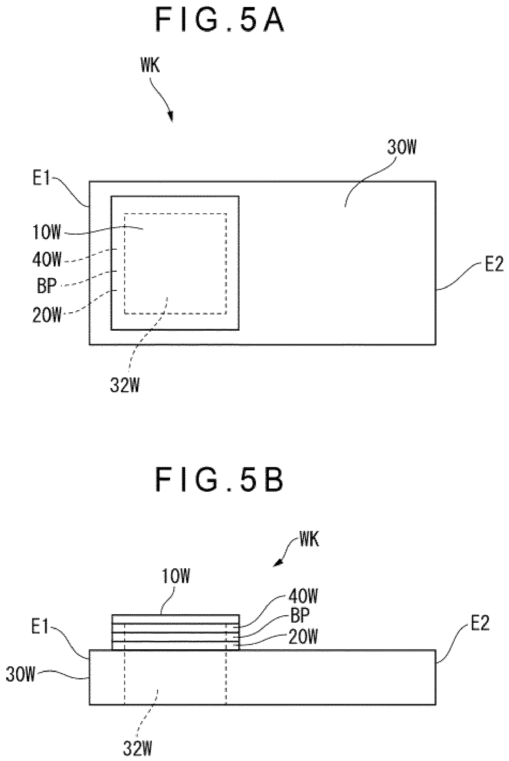

How a pellicle according to Example 1 is produced will be described with reference to Figs. 5A and 5B. Fig. 5A is a schematic plan view of a pellicle WK as viewed in plan from a pellicle film 10W side. Fig. 5B is a schematic side view of the pellicle WK as viewed from a side along a short direction.

An acrylic plate (2 cm × 5 cm × 2 mm) having an opening 32W of 1 cm×1 cm size was prepared as a support member 30W. The opening 32W is located in the vicinity of the center of the support member 30W on the first end E1 side.

Vertically oriented MWCNT was prepared as a first reinforcing layer 40W. The MWCNT was formed on an SUS substrate BP with a height of 0.25 mm.

Subsequently, the substrate BP was fixed using a double-stick tape (an adhesion member 20W) on the support surface of the support member 30W at the peripheral portion of the opening 32W (in this example, a 5-mm width area from a periphery of the opening 32W). The support member 30W (pellicle support) including the first reinforcing layer 40W was thus prepared.

Subsequently, SWCNT was dispersed in water to prepare a SWCNT dispersion. The SWCNT dispersion was filtrated using a membrane filter to form the pellicle film 10W in a form of a film consisting solely of SWCNT on the membrane filter. The membrane filter was entirely immersed in water to isolate the pellicle film 10W consisting solely of SWCNT on the surface of the water.

The support member 30W having the first reinforcing layer 40W was immersed in water in which the pellicle film 10W was isolated, and the support member 30W was then lifted from the water to pick up the pellicle film 10W as a self-supported film such that the pellicle film 10W covered the opening 32W and was supported on the first reinforcing layer 40W. The pellicle WK was produced as described above. In the pellicle WK, the pellicle film 10W (CNT self-supported film) was integrated with the support member 30W and was reinforced by the first reinforcing layer 40W.

### Reference Example 1

A pellicle according to Reference Example 1 was produced in the same manner as Example 1 except that, in the process of producing the pellicle according to Example 1, the dispersion of MWCNT was added dropwise and dried in advance on an outer periphery of the opening 32W to form MWCNT oriented in the horizontal direction as the first reinforcing layer 40W.

### Comparative 1

A pellicle according to Comparative 1 was produced in the same manner as Example 1 except that, in the process of producing the pellicle in Example 1, the pellicle film 10W was picked up as the self-supported film so as to cover the opening 32W, without providing the first reinforcing layer 40W on the support member 30W.

### Comparative 2

A pellicle according to Comparative 2 was produced in the same manner as Example 1 except that the SUS substrate BP provided with no first reinforcing layer 40W was attached to the support member 30W using the adhesion member 20W (double-stick tape) and the pellicle film 10W was picked up as the self-supported film so as to be supported on the substrate BP.

### Evaluation of Impact Resistance

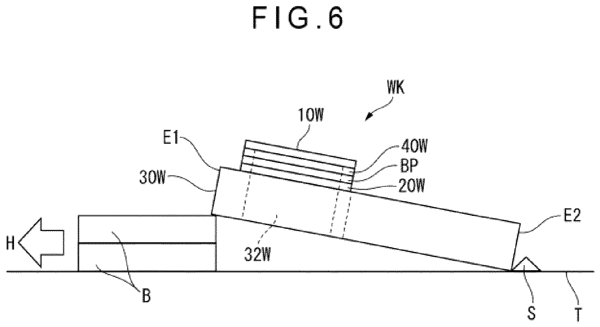

The evaluation was performed according to the following procedure. Fig. 6 schematically illustrates a method of evaluating the strength of a pellicle film using the pellicle WK, and illustrates the pellicle WK as viewed from the side along the short direction. As illustrated in Fig. 6, the pellicle WK was first placed on a horizontal base T. A stopper S was disposed so as to be in contact with a second end E2 side of the pellicle WK. Next, with the second end E2 side of the pellicle WK being kept from slipping, the first end E1 side was lifted up, and a plate member B having a thickness of 1 mm was inserted between the base T and the pellicle WK. Next, the plate member B was pulled out in a horizontal direction H to drop the pellicle WK. After the pellicle WK dropped, whether there was breakage of the pellicle film 10W was visually checked. When there was no breakage, another plate member B having a thickness of 1 mm was stacked up, and the two plate members B were inserted and pulled out in the horizontal direction H to drop the pellicle WK. This operation was repeated until the pellicle film 10W suffered breakage, and a maximum drop height at which the pellicle film 10W did not suffer breakage was evaluated as the impact resistance of the pellicle film 10W. The maximum height corresponds to the maximum number of stacked plate members B having a thickness of 1 mm. In the impact resistance evaluation of the pellicle film 10W, the test according to the above procedure was performed three times, and the average of the three tests was employed. The results of the impact resistance evaluation of the pellicles according to Example 1, Reference Example 1, and Comparatives 1 and 2 are shown in Table 1.

**Table 1**

| | 1st Reinforcing Layer | Evaluation of Impact Resistance |
|---|---|---|
| Example 1 | Vertically-oriented MWCNT | 27 mm |
| Reference Example 1 | Horizontally-oriented MWCNT | 11 mm |
| Comparative 1 | None | 8 mm |
| Comparative 2 | None | 9 mm |

As shown in Table 1, by providing the first reinforcing layer between the pellicle film and the support member, the pellicle film according to Example 1 is less likely to be damaged as compared with the pellicle films according to Comparatives 1 and 2, which have no first reinforcing layer, so that the impact resistance of the pellicle is improved. The pellicle according to Example 1, in which MWCNT in the first reinforcing layer is oriented in the vertical direction, exhibits further improved impact resistance as compared with the pellicle according to Reference Example 1 having the first reinforcing layer in which MWCNT is oriented in the horizontal direction. Further, the first reinforcing layer, which is made of carbon nanotubes to have excellent heat resistance, is unlikely to be decomposed even when being irradiated with high-energy light (e.g., EUV).

### EXPLANATION OF CODES

10...pellicle film, 10W...pellicle film, 11...first pellicle film surface, 12...second pellicle film surface, 13...peripheral portion, 20W...adhesion member, 30...support member 30A...pellicle support 30W...support member, 31...frame, 32...opening, 32W...opening, 34...support surface, 40...first reinforcing layer, 40W... first reinforcing layer, 50...second reinforcing layer, 100... pellicle, 110...pellicle, B...plate-shaped member, BP...substrate, E1...first end, E2...second end, S...stopper, T...base, WK...pellicle

## Claims

1. A pellicle comprising:
a pellicle film;
a support member comprising a frame and an opening surrounded by the frame, the support member supporting the pellicle film; and
a first reinforcing layer configured to reinforce the pellicle film, wherein
the frame has a support surface facing the pellicle film,
the pellicle film has a first pellicle film surface facing the support member and a second pellicle film surface opposite the first pellicle film surface,
the first reinforcing layer is disposed in an area where the pellicle film overlaps the support member in a plan view of the pellicle film supported by the support member, on a side of the first pellicle film surface between the pellicle film and the support member,
the first reinforcing layer contains at least one material selected from the group consisting of carbon nanotube, graphene, graphite, diamond-like carbon, amorphous carbon, silicon, silicon carbide, silicon nitride, and boron nitride, and
when the first reinforcing layer contains carbon nanotubes, the carbon nanotubes in the first reinforcing layer are oriented in a vertical direction with respect to the support surface of the frame.

2. The pellicle according to claim 1, wherein the pellicle film is an inorganic thin film or an organic thin film.

3. The pellicle according to claim 1, wherein the pellicle film contains at least one material selected from the group consisting of carbon nanotubes, graphene, graphite, diamond-like carbon, amorphous carbon, silicon, silicon carbide, silicon nitride, and boron nitride.

4. The pellicle according to claim 1, wherein the pellicle film includes carbon nanotubes.

5. The pellicle according to any one of claims 1 to 4, wherein a material of the pellicle film is the same as a material of the first reinforcing layer.

6. The pellicle according to any one of claims 1 to 4, further comprising:
a second reinforcing layer disposed on a side of a second pellicle film surface.

7. The pellicle according to claim 6, wherein the second reinforcing layer contains at least one material selected from the group consisting of carbon nanotube, graphene, graphite, diamond-like carbon, amorphous carbon, silicon, silicon carbide, silicon nitride, and boron nitride.

8. The pellicle according to claim 7, wherein
the second reinforcing layer includes carbon nanotubes, and
the carbon nanotubes in the second reinforcing layer are oriented in a parallel direction with respect to the support surface of the frame.

9. A pellicle support for supporting a pellicle film, the pellicle support comprising:
a frame; and
an opening surrounded by the frame, wherein
the frame has a support surface facing the pellicle film when the frame supports the pellicle film,
a first reinforcing layer is disposed at an outer periphery of the opening on the support surface of the frame,
the first reinforcing layer contains at least one material selected from the group consisting of carbon nanotube, graphene, graphite, diamond-like carbon, amorphous carbon, silicon, silicon carbide, silicon nitride, and boron nitride, and
when the first reinforcing layer contains carbon nanotubes, the carbon nanotubes in the first reinforcing layer are oriented in a vertical direction with respect to the support surface of the frame.

10. A method for producing a pellicle using the pellicle support according to claim 9, the method comprising:
attaching the pellicle film to a side of the support surface of the frame such that the pellicle film covers the opening and is supported by the first reinforcing layer.

11. The method for producing a pellicle according to claim 10, further comprising:
before attaching the pellicle film to the pellicle support, disposing a second reinforcing layer on a second pellicle film surface of the pellicle film opposite a first pellicle film surface facing the pellicle support, wherein
in the disposing of the second reinforcing layer, the second reinforcing layer is disposed at a position where the pellicle film, the pellicle support, and the first reinforcing layer overlap each other when the pellicle film is viewed in a plan after attaching the pellicle film to the pellicle support.

12. The method for producing a pellicle according to claim 10, further comprising:
disposing the second reinforcing layer in an area on a second pellicle film surface of the pellicle film opposite a first pellicle film surface facing the pellicle support, the area being where the pellicle film overlaps the pellicle support in a plan view of the pellicle film.

13. The method for producing a pellicle according to claim 11 or 12, wherein the second reinforcing layer contains at least one material selected from the group consisting of carbon nanotube, graphene, graphite, diamond-like carbon, amorphous carbon, silicon, silicon carbide, silicon nitride, and boron nitride.

14. The method for producing a pellicle according to claim 13, wherein
the second reinforcing layer includes carbon nanotubes, and
the second reinforcing layer is formed such that the carbon nanotubes in the second reinforcing layer are oriented in a parallel direction with respect to a film surface of the pellicle film.
